(19) Europäisches Patentamt
European Patent Office
Office européen des brevets

(11) **EP 2 006 692 A2**

(12) **EUROPEAN PATENT APPLICATION**
published in accordance with Art. 153(4) EPC

(43) Date of publication:
**24.12.2008 Bulletin 2008/52**

(51) Int Cl.:
***G01R 27/02*** *(2006.01)* ***H04B 3/46*** *(2006.01)*

(21) Application number: **07720245.5**

(22) Date of filing: **13.02.2007**

(86) International application number:
**PCT/CN2007/000497**

(87) International publication number:
**WO 2007/109964 (04.10.2007 Gazette 2007/40)**

(84) Designated Contracting States:
**AT BE BG CH CY CZ DE DK EE ES FI FR GB GR HU IE IS IT LI LT LU LV MC NL PL PT RO SE SI SK TR**

(30) Priority: **28.03.2006 CN 200610058470**
**23.05.2006 CN 200610080637**

(71) Applicant: **Huawei Technologies Co., Ltd.**
**Longgang District, Shenzhen**
**Guangdong 518129 (CN)**

(72) Inventors:
• **LI, Fei**
**Guangdong 518129 (CN)**
• **XU, Guijin**
**Guangdong 518129 (CN)**

(74) Representative: **Hengelhaupt, Jürgen et al**
**Gulde Hengelhaupt Ziebig & Schneider**
**Patentanwälte - Rechtsanwälte**
**Wallstrasse 58/59**
**10179 Berlin (DE)**

(54) **A SAMPLE CHANNEL SIGNAL CALIBRATING METHOD FOR IMPEDANCE TESTING AND AN IMPEDANCE TESTING METHOD**

(57)     A sample channel signal calibrating method for impedance testing, includes: testing the voltage value of the same testing signal using at least two sampling channels, and take the obtained ratio value of voltages as a channel difference parameter of the sample channels; connecting a tested impedance to the voltage output terminal of the sample resistance of the signal source output channel, and testing the input voltages of an end of the sampling resistance respectively in the at least two sample channels to obtain respective voltage testing values; obtaining the ratio of each voltage testing value to the corresponding real voltage value based on the channel difference parameter and the voltage testing values. An impedance testing method is based on the calibrating method, and in this method, making the ratio substituted into the impedance calculating formula of the tested impedance to obtain the impedance value. In the present invention, the impedance testing result is calibrated by sampling channel difference parameter.

Fig. 8

**Description**

The present application claims the priority of Chinese Patent Application No. 200610080637.1 filed with the State Intellectual Property Office of China on May 23, 2006, entitled "METHOD FOR IMPEDANCE TESTING", and the priority of Chinese Patent Application No. 200610058470.9 filed with the State Intellectual Property Office of China on March 28, 2006, entitled "METHOD FOR TESTING DUAL-PORT NETWORK PARAMETERS", the entire contents of which are incorporated in the present application by reference.

**Field of the Invention**

The present invention relates to the testing field, and particularly to a method for calibrating a sampling channel signal in impedance testing and a method for impedance testing.

**Background of the Invention**

In the telecommunication field, an operator provides a wideband telecommunication service and a narrowband telecommunication service to a user simultaneously via local cables (usually twisted pair wire), such as Asymmetrical Digital Subscriber Line over Plain Old Telephone Services (ADSL over POTS), Asymmetrical Digital Subscriber Line over Integrated Services Digital Network (ADSL over ISDN), very high DSL over Plain Old Telephone Services (VDSL over POTS), ISDN over VDSL (VDSL over ISDL) and the like, and these kinds of applications have been widespread at home and aboard.

During the operation and maintenance of these services, it often needs to test parameters of a user line, wherein the impedance testing of the line is a kind of relatively important testing. For example, in the present market, a wideband line testing product adopts a method for deriving the insertion loss of an XDSL service frequency range of a line by testing the low frequency impedance characteristic of the line. In this method, the precision of the impedance will directly affect the testing result, so the requirement for the test precision of the impedance is relatively strict.

At present, there have been usually adopted the following two impedance testing methods.

Method 1:

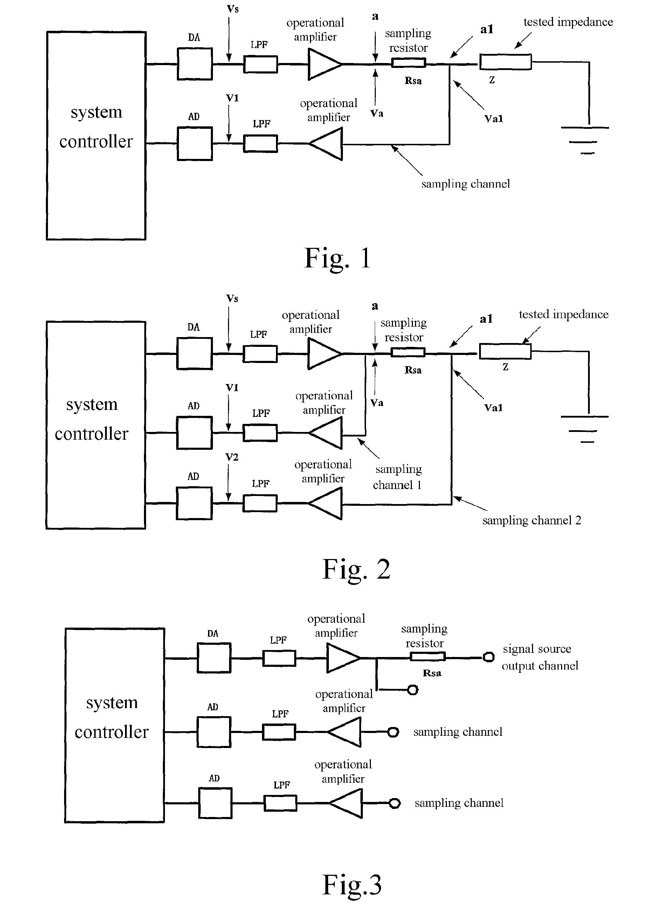

As shown in Figure 1, during the testing, a signal source output channel is connected to one end of tested impedance via a sampling resistor. The signal source output channel outputs a signal source Vs, which, after signal processing, is input to an end of the sampling resistor, node a, and is output through another end of the sampling resistor, node al. One end of the tested impedance is connected to the node al of the sampling resistor, and another end thereof is grounded. A sampling channel is connected to the node al, and the voltage value of the node al is measured to be V1. Assuming the real voltage values of the two end nodes a and al of the sampling resistor are Va and Val, according to Ohm's law and the voltage division theory, the impedance value of the tested impedance can be represented as:

$$Z = Val/Iz = \frac{Val}{(Va - Val)/Rsa} = Rsa \Big/ \left( \frac{Va}{Val} - 1 \right) \quad \ldots\ldots\ldots\ldots (1)$$

By approximating the input voltage Va of the end node a of the sampling resistor as an output signal source Vs of the signal source output channel and substituting Vs and V1 into the formula (1), the following relational expression is obtained:

$$Z = Rsa \Big/ \left( \frac{Vs}{V1} - 1 \right) \quad \ldots\ldots\ldots\ldots\ldots\ldots\ldots\ldots (2)$$

By substituting the values of Vs and V1 into formula (2), the impedance value can be calculated.

In the present technical solution, the input voltage of the sampling resistor, Va, is approximated as the output signal source, Vs, of the signal source output channel. However, there is inevitably a transmission loss due to the impacts of signal processing and line impedance in the signal source output channel during the transmission. Compared with Vs, Va has an attenuation in amplitude (for a DC or AC signal) and a deviation in phase (for an AC signal) with respect to Vs. Obviously, if Va of the node a is substituted approximately by the value Vs of the output signal source, the calculation precision of the impedance will be greatly degraded.

Method 2:

As shown in Figure 2, the connection relationship of the signal source output channel and the tested impedance is identical to that of Method 1, and the difference lies in that, in addition to testing the output voltage Val of the end node al of the sampling resistor, a sampling channel further tests the input voltage Va of the other end node a of the sampling resistor. It is assumed that sampling channels test node a to obtain a tested voltage value V1 and tests node al to obtain a tested voltage value V2. In a similar way, according to formula (1), the tested value V1 of Va and the tested value V2 of Val are substituted into the formula (1) to obtain:

$$Z = V2 \big/ \big[ (V1-V2) \big/ Rsa \big] = Rsa \big/ \left( \frac{V1}{V2} - 1 \right) \ldots \ldots \ldots \ldots (3)$$

By substituting the values of the tested values V1 and V2 into formula (3), the impedance value can be calculated.

Compared to Method 1, Method 2 avoids the transmission attenuation error of the signal source output channel for a signal and relatively enhance the precision of the impedance since it directly tests and obtains the input voltage value of the sampling resistor rather than adopts the way that Va of node a is approximated as the signal source Vs. However, in signal testing, any signal passing through a sampling channel will suffer certain signal attenuation inevitably due to signal loss during signal processing and line impedance loss. Specifically, the signal has attenuation in amplitude (for a DC or AC signal) and a deviation in phase (for an AC signal). So there still exists a test error which makes the obtained impedance precision low during testing by means of Method 2.

**Summary of the Invention**

Embodiments of the disclosure provide a method for calibrating a sampling channel signal in impedance testing and a method for impedance testing so as to obtain an impedance value with a high precision.

The method for calibrating a sampling channel signal during impedance testing, provided by the embodiments of the disclosure includes the steps of:

testing the voltage of a same testing signal by using at least two sampling channels, and taking the ratio of the obtained tested voltage values as a channel variance parameter between sampling channels;

connecting a tested impedance to the voltage output end of a sampling resistor in a signal source output channel, outputting a testing signal by the signal source output channel, and testing by the at least two sampling channels the voltages of a terminal of the sampling resistor, respectively, to obtain respective tested voltage values; and

obtaining the ratio between the real voltage values corresponding to the tested voltage values, based on the channel variance parameter and the tested voltage values.

The method for impedance testing provided by the embodiments of the disclosure includes the steps of:

testing the voltage of a same testing signal by using at least two sampling channels, and taking the ratio of the obtained tested voltage values as a channel variance parameter between sampling channels;

connecting a tested impedance to the voltage output terminal of a sampling resistor in a signal source output channel, outputting a testing signal by the signal source output channel, and testing by the at least two sampling channels the voltages of an end of the sampling resistor, respectively, to obtain respective tested voltage values;

obtaining the ratio between the real voltage values corresponding to the tested voltage values, based on the channel variance parameter and the tested voltage values; and

obtaining the impedance value of the tested impedance by using the ratio between the real voltage values.

Because the channel sampling signal calibration is adopted, the sampling channel variance parameter which reflects the variance between attenuation degrees of the testing signal passing through sampling channels can be obtained; by substituting the variance parameter into the impedance calculation formula and calibrating the tested values, the test error of a signal during the sampling testing for the sampling channels due to the variance between the attenuation degrees of the signal passing through the sampling channels is reduced and the precision of the impedance testing is greatly enhanced.

## Brief Descriptions of the Drawings

Figure 1 is a schematic diagram of the first method for the impedance testing in the prior art;

Figure 2 is a schematic diagram of the second method for the impedance testing in the prior art;

Figure 3 is a schematic diagram of an impedance testing device according to an embodiment of the disclosure;

Figure 4 is a schematic diagram of the first sampling channel signal calibrating method according to an embodiment of the disclosure;

Figure 5 is a schematic diagram of another sampling channel signal calibrating method according to an embodiment of the disclosure;

Figure 6 is a first schematic diagram of the impedance testing method according to an embodiment of the disclosure;

Figure 7 is a schematic diagram of a dual-port network;

Figure 8 is a schematic diagram of a test of an impedance parameter component $Z_{11}$ adopted by the impedance testing method according to an embodiment of the disclosure;

Figure 9 is a schematic diagram of a test of an impedance parameter component $Z_{22}$ adopted by the impedance testing method according to an embodiment of the disclosure;

Figure 10 is a schematic diagram of a test of impedance parameter components $Z_{12}$ and $Z_{21}$ adopted by the impedance testing method according to an embodiment of the disclosure; and

Figure 11 is a schematic diagram of another test of impedance parameter components $Z_{12}$ and $Z_{21}$ adopted by the impedance testing method according to an embodiment of the disclosure.

## Detailed Descriptions of the Embodiments

In an embodiment of the disclosure, a voltage of a same signal is tested by sampling channels to obtain respective tested values. The ratio of the tested values acts as a variance parameter of the sampling channels. The channel variance parameter represents the variance of the sampling channels, particularly the variance of the influences of the sampling channels on the amplitude and phase of a real signal at a tested point, and specifically appears as the variance of the attenuation degrees of the amplitude and phase between the tested voltage value of a sampling channel and the real value of the same tested voltage. A tested impedance is connected to the output end of a sampling resistor of a sampling channel connected to the signal source output channel, and according to Ohm's law and the voltage division theory, the impedance value of the tested impedance is represented by the input and output voltages of the sampling resistor and the impedance value of the sampling resistor, and thus an impedance formula. the input voltages of the sampling resistor and the input voltages of the tested impedance are tested by the sampling channels to obtain corresponding tested voltage values, and then the channel variance parameter is multiplied by the ratio of the tested voltage values to obtain the ratio of the real voltage values, and the ratio of the real voltage values is substituted into the impedance formula to obtain a impedance value with high precision.

In order to facilitate understanding of the technical solution according to the embodiments of the disclosure, a detailed description will be further made below in conjunction with the accompany drawings.

In Figure 3, a testing device for impedance testing according to an embodiment of the disclosure is shown. The impedance testing device includes a system controller, a signal source output channel and sampling channels, wherein the signal source output channel and the sampling channels are connected to the system controller respectively, and are controlled by the system controller. The output end of the signal source output channel is connected in series to a sampling resistor. A testing signal is output from the signal source output channel, and the sampling channels are used for sampling testing, wherein the signal source output channel and the sampling channels may be increased according to the practical requirements of the test.

The system controller may select one of DSP, CPU, FPGA or a combination thereof according to the requirements of the system. The channel is composed of a digital to analog converter DA, a low-pass filter LPF, an operational amplifier and a sampling resistor. The digital signal source output from the system controller is converted into an analog signal by the DA, and the analog signal is processed through the LPF and the operational amplifier so that a testing signal with a better quality is obtained and is inputted into a sampling resistor, and subsequently the testing signal is divided through the sampling resistor and is output.

Each of the sampling channels includes an operational amplifier, an LPF and an analog-digital (AD) converter. Sampling signal is processed by the operational amplifier and the LPF of the sampling channel, and then the processed sampling signal is input to the AD converter. The analog signal is converts into a digital signal by the AD converter, and subsequently the digital signal is input to the system controller which performs signal processing on the sampling signal. The sampling channel is a channel used to test voltage, and the current which passes through the sampling channel may be neglected.

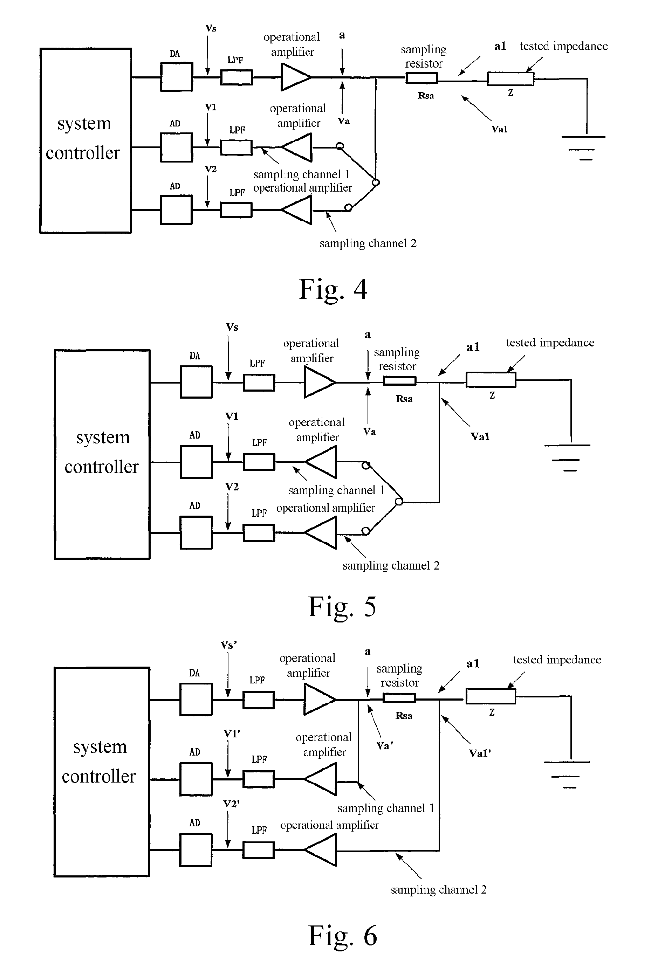

In Figure 4, a schematic diagram of a method for calibrating a sampling channel signal according to an embodiment of the disclosure is shown. Sampling channel 1 and sampling channel 2 are connected to the node a of the signal source output channel, respectively. The signal source output channel outputs a signal source. It is assumed that the real voltage of node a is Va. The node a is respectively tested by the two sampling channels so as to obtain the testing results of the sampling channels 1 and 2 which are V 1and V2, respectively. It is assumed that:

$$A1 = V1/Va \dots\dots\dots\dots\dots\dots\dots\dots(4)$$

$$A2 = V2/Va \dots\dots\dots\dots\dots\dots\dots(5)$$

$$A = A1/A2 = V1/V2 \dots\dots\dots \dots\dots(6)$$

wherein A1, A2 or A can be a real number or a complex number.

Obviously, A1 and A2 can be used to represent the attenuation degrees for the signal Va which passes through the sampling channels 1 and 2 during signal transmission, respectively, so the proportion value of A1 and A2 can be used to represent the variance between the attenuation degrees for a signal which passes through the sampling channels 1 and 2 during signal transmission. A represents a sampling channel variance parameter. By substituting the numerical values of tested values V1 and V2 corresponding to Va and Va1 into formula (6), the value of the sampling channel variance parameter can be calculated.

The sampling channel variance parameter can be determined by the following way:

$$\text{assuming} \quad A1 = \frac{Va1}{V1} \quad \text{and } A2 = \frac{Va1}{V2}, \text{ then } \quad A = \frac{A1}{A2} = \frac{V2}{V1}.$$

It should be noted that, in the process of calibrating the sampling channel signal, it is enough as long as it is ensured the signals tested by sampling channels are completely identical to each other, and it is not necessarily required that each of the tested points must be a certain point on one of the sampling channel, or the tested points must be tested simultaneously. Just for convenience, a certain point is preferably selected on the signal source output channel to connect the sampling channels to this point, and the signal of this point is tested, thereby testing and calibrating the signals of the signal source output channels.

In Figure 5, another point connection of the method for calibrating a sampling channel signal according to another embodiment is shown. That is, the tested point may alternatively be a node a1 having a low level of the sampling resistor, and the method for obtaining and calculating the channel variance parameter of the sampling channels is the same as that mentioned above. As shown in Figure 5, the node a1 of the sampling resistor is tested by the sampling channels to obtain a sampling channel variance parameter, the principle of which is similar to the method for calibrating a sampling channel signal as shown in Figure 4.

In Figure 6, a schematic diagram of an impedance testing method according to the disclosure is shown. As shown in the Figure 6, one end of the tested impedance is grounded, the other end is connected to the sampling resistor of the signal source output channel, and the signal source output signal is output to the tested impedance via the sampling resistor. A signal source output from the signal source output channel is input to the sampling resistor through a series of processes for signal, and then is output to the tested impedance via the sampling resistor. Based on the condition of circuit connection, assuming that the real voltage at two end nodes a and a1 of the sampling resistor should be Va' and Va1', respectively, it can be derived from Ohm's law and the voltage division theory that:

$$Z = Rsa/(Va'/Va1' - 1) \dots\dots\dots\dots\dots(7)$$

Sampling channels 1 and 2 are connected to the two end nodes a and a1 of the sampling resistor, and the signals are tested at the two nodes, respectively, where the tested value of node a obtained by sampling channel 1 is *V*1', and the tested value of node al obtained by sampling channel 2 is *V*2'.

In combination with the above result of calibrating the sampling channel signal, since the sampling channels remain unchanged, the attenuation degrees for the signals passing through the sampling channels can be considered unchanged, i.e., A1, A2 and A is constant, so the following formula are provided:

$$\text{For sampling channel 1:} \quad A1 = \frac{V1'}{Va'} \ldots\ldots\ldots\ldots\ldots(8),$$

$$\text{For sampling channel 2:} \quad A2 = \frac{V2'}{Va1'} \ldots\ldots\ldots\ldots..(9)$$

By substituting (8) and (9) into formula (7), the following formula is obtained:

$$Z = Rsa \Big/ (Va' \Big/ Va1' - 1) = Rsa \Big/ [(V1' \Big/ A1 \Big/ V2' \Big/ A2) - 1] \ldots\ldots(10)$$

By substituting the tested values *V*1' and *V*2' and the sampling variance parameter A obtained by calibrating the sampling channel signal into formula (10), the impedance value Z can be obtained.

Hereinafter, the method of the disclosure will be described by taking as an example that the tested impedance is a dual-port network.

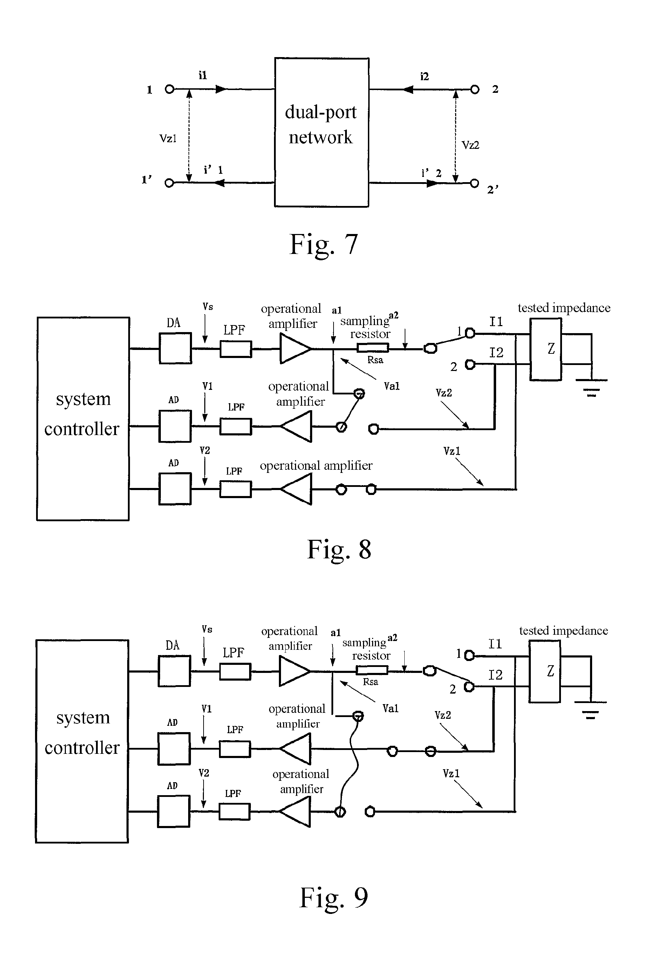

A dual-port network is shown in Figure 7 and its impedance parameter can be expressed as $Z = \begin{bmatrix} Z11 & Z12 \\ Z21 & Z22 \end{bmatrix}$ . According to the characteristic of the dual-port network, $\begin{bmatrix} Vz1 \\ Vz2 \end{bmatrix} = \begin{bmatrix} Z11 & Z12 \\ Z21 & Z22 \end{bmatrix} \times \begin{bmatrix} I1 \\ I2 \end{bmatrix}$ can be derived and may be transformed into an equation form as

$\begin{cases} Vz1 = I1 \cdot Z11 + I2 \cdot Z12 \\ Vz2 = I1 \cdot Z21 + I2 \cdot Z22 \end{cases}$ . When I2=0, there is provided $\begin{cases} Z11 = \frac{Vz1}{I1} \\ Z21 = \frac{Vz2}{I1} \end{cases}$ , and thus $\begin{cases} Z11 = \frac{Vz1}{I1} \\ Z21 = \frac{Vz2}{Vz1} \cdot Z11 \end{cases}$ is

derived; and when I1=0, there is provided $\begin{cases} Z12 = \frac{Vz1}{I2} \\ Z22 = \frac{Vz2}{I2} \end{cases}$ , and thus $\begin{cases} Z12 = \frac{Vz1}{Vz2} \cdot Z22 \\ Z22 = \frac{Vz2}{I2} \end{cases}$ is derived. Therefore the values of Z11, Z21, Z12 and Z22 can be calculated by testing port parameters Vz1, Vz2, I1 and I2, thereby obtaining the impedance parameter Z. Because the data of the port parameters is obtained by testing, test error can be introduced during the test and will directly result in the calculation result with an error. So, it becomes very important how to reduce the test error and enhance the test precision of a parameter.

As shown in Figure 8, the dual-port network parameters Z11 or Z22 are firstly tested, and Z11 is taken as an example in the present embodiment. The port 2 of the dual-port network is disconnected, the port 1 of the dual-port network is connected to one end node a2 of the sampling resistor and sampling channel 2, wherein the end node a2 is a low level. The voltage input node a1 of the sampling resistor Rsa on the signal source input line is connected to sampling channel 1. A signal source signal is output through the signal source output channel, and the signal source signal is output and connected to port 1 of the dual-port network through the sampling resistor. Since 12=0, when the real voltage value Val at the node al is tested by sampling channel 1, the obtained tested value is V1, and when the real input voltage value Vz1 of the port 1 of the dual-port network is tested by the sampling channel 2, the obtained tested voltage value is V2. Therefore, according to the principle of the dual-port network, there is provided $\begin{cases} Vz1 = I1 \cdot Z11 \\ Vz2 = I1 \cdot Z21 \end{cases}$

from which $Z11 = \dfrac{Vz1}{I1} = \dfrac{Vz1 \cdot Rsa}{Va1 - Vz1} = \dfrac{Rsa}{Va1/Vz1 - 1}$ is derived, thereby obtaining Z11.

According to the result of calibrating the above sampling channel signal, and in combination with the circuit connection relationship tested in the present embodiment, $Va1 = V1 \cdot A1$, $Vz1 = V2 \cdot A2$, and $\dfrac{A1}{A2} = A$, the ratio

between the real voltage values are derived as: $\dfrac{Va1}{Vz1} = \dfrac{V1}{V2} \cdot \dfrac{A1}{A2} = \dfrac{V1}{V2} \cdot A$, where A1, A2 and A are real numbers or complex numbers. To calibrate Z11, the ratio $\dfrac{Va1}{Vz1} = \dfrac{V1}{V2} \cdot A$ is substituted, and thereby

$Z11 = \dfrac{Rsa}{V1 \cdot A/V2 - 1} = \dfrac{V2 \cdot Rsa}{V1 \cdot A - V2}$ is thereby $Z11 = \dfrac{Rsa}{V1 \cdot A/V2 - 1} = \dfrac{V2 \cdot Rsa}{V1 \cdot A - V2}$ is obtained.

Similarly, as shown in Figure 9, if I1=0, Z22 can be obtained. Port 1 of the dual-port network is disconnected, and the sample channel 1 is connected to port 2 of the dual-port network and the output node a2 of the sampling resistor on the signal source output channel, to test the voltage Vz2 of port 2. Sampling channel 2 is connected to voltage input node al of the sampling resistor to tested voltage Val inputting into the sampling resistor. A signal source signal is input into port 2 of the dual-port network through sampling resistor. Since I1=0, the voltage values obtained by sampling channels 1 and 2 are V1 and V2, respectively. According to the principle of the dual-port network, there is obtained:

$$Z22 = \frac{Vz2}{I2} = \frac{Rsa}{Va1/Vz2 - 1},$$

thereby obtaining Z22.

Finally, by using the above sampling channel signal calibration result and the test line connection relationship at this time, $Va1 = V2 \cdot A2$, $Vz2 = V1 \cdot A1$ are obtained and meantime $\dfrac{A1}{A2} = A$, and thus the ratio value between the real voltage values is derived as $\dfrac{Va1}{Vz2} = \dfrac{V2}{V1} \cdot \dfrac{A2}{A1} = \dfrac{V2}{V1 \cdot A}$. By substituting the ratio into the above formula

regarding Z22, $Z22 = \dfrac{Rsa}{V2/V1 \cdot A - 1} = \dfrac{Rsa \cdot V1 \cdot A}{V2 - V1 \cdot A}$ can be obtained.

To obtain Z12 and Z21, according to Z11 and Z22 obtained from the above test, and the dual-port relationship

$\begin{cases} Z21 = \dfrac{Vz2}{Vz1} \cdot Z11 \\ Z12 = \dfrac{Vz1}{Vz2} \cdot Z22 \end{cases}$, and Z21 can be calculated as follows specifically.

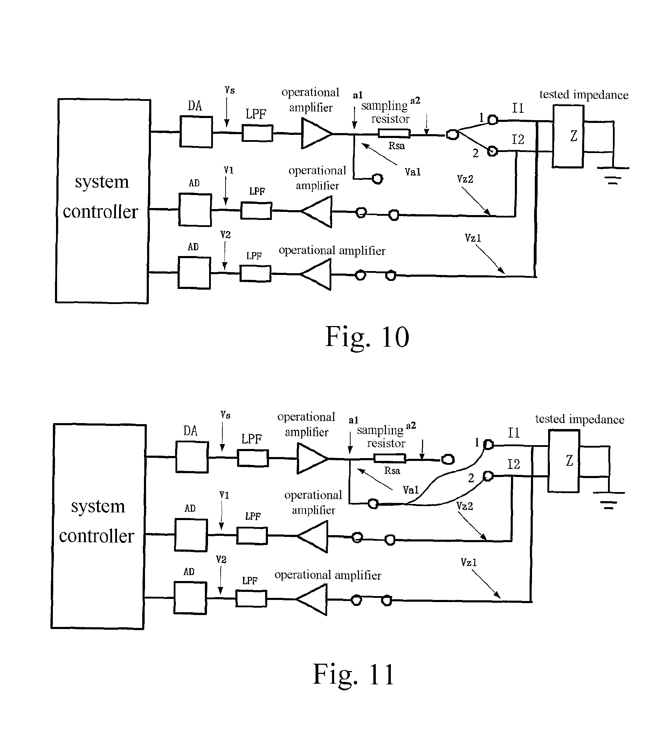

As shown in Figure 10, ports 1 and 2 of the dual-port network are connected to sampling channel 2 and 1, respectively, and voltage output node a2 of the sampling resistor in the signal source output channel is connected to ports 1 and 2 of dual-port network. A signal source signal is input, and the voltage Va2 of the node a2 is tested by sampling channels 1 and 2 to obtain the tested voltage values V1 and V2.

According to the above sampling channel signal calibration result and the line connection relationship of the present embodiment, $Vz1 = V2 \cdot A2$, $Vz2 = V1 \cdot A1$ is obtained. So the ratio between the real voltage values is

$$\frac{Vz2}{Vz1} = \frac{V1 \cdot A1}{V2 \cdot A2} = \frac{V1 \cdot A}{V2}$$ , and there is further obtained $Z12 = \frac{V2}{V1 \cdot A} \cdot Z22$ , $Z12 = \frac{V1 \cdot A}{V2} \cdot Z11$ .

Of course, when Z12 and Z21 are tested, any point on the signal output channel can be selected as a tested point to be connected with the two sampling channels, respectively, and the sampling channels test the voltage values of the tested point. As shown in Figure 11, the difference between Figure 11 and Figure 10 lies in that the voltage input node of the sampling resistor is selected as a tested point in the present embodiment, and the voltage input node is connected to the sampling channels for testing. The calculation method is as above.

In the implementation of the disclosure, the signal source tested each time may be a DC signal or an AC signal and may also be a modulated wave signal with a plurality of frequencies superposed. Since a plurality of sampling tests is usually needed in the practical testing, the modulated wave signal with a plurality of frequencies superposed is often chosen during a practical application.

The above is a detailed description of the impedance testing method according to the disclosure. While the principle and specific embodiments of the disclosure have been described in detail, the above description of the embodiments is only used to better understand the method and concept of the disclosure. Meantime, it will be appreciated by those skilled in the art that according to the concept of the disclosure, various changes in form and details may be made without departing from the spirit and scope of the disclosure. In sum, the contents of the present specification should not be construed as a limitation to the disclosure.

## Claims

1.   A method for calibrating a sampling channel signal in impedance testing, **characterized by** comprising:

   testing, by using at least two sampling channels, the voltage of a same testing signal, and taking the ratio of the obtained tested voltage values as a channel variance parameter between sampling channels;
   connecting a tested impedance to the voltage output end of a sampling resistor in a signal source output channel, and outputting by the signal source output channel a testing signal, and then testing by the at least two sampling channels the voltages of an end of the sampling resistor, respectively, to obtain respective tested voltage values; and
   obtaining the ratio between the real voltage values corresponding to the tested voltage values based on the channel variance parameter and the tested voltage values.

2.   The method according to claim 1, wherein signal voltage values of an end of the sampling resistor at a same time is measured as the tested voltage values of the sampling channels.

3.   The method according to claim 1, wherein the ratio between the real voltage values is obtained by the channel variance parameter multiplied by the ratio between the tested voltage values.

4.   The method according to claim 1, wherein the signal is a DC signal.

5.   The method according to claim 1, wherein the signal is an AC signal.

6.   The method according to claim 4 or 5, wherein the signal is a modulated signal.

7.   An impedance testing method, comprising:

   testing, by using at least two sampling channels, the voltage of a same testing signal, and taking the ratio of the obtained tested voltage values as a channel variance parameter between sampling channels;
   connecting a tested impedance to the voltage output end of a sampling resistor in a signal source output channel, outputting by the signal source output channel a testing signal, and then testing by the at least two sampling channels the voltages of an end of the sampling resistor, respectively, to obtain respective tested voltage values;
   obtaining the ratio between the real voltage values corresponding to the tested voltage values based on the channel variance parameter and the tested voltage values; and
   obtaining, by using the ratio between the real voltage values, the impedance value of the tested impedance.

8.   The method according to claim 7, wherein voltage signal values of an end of the sampling resistor at a same time is measured as the tested voltage values of the sampling channels.

Fig. 1

Fig. 2

Fig.3

Fig. 4

Fig. 5

Fig. 6

Fig. 7

Fig. 8

Fig. 9

Vs    operational   a1             a2              tested impedance
DA    LPF   amplifier   sampling                      I1
                        resistor
                        Rsa                    1        I2
                                                        Z
                operational          Va1    Vz2    2
AD    LPF   amplifier
V1
AD                                              Vz1
V2    LPF   operational amplifier
AD    LPF

system
controller

Fig. 10

Vs    operational   a1             a2              tested impedance
DA    LPF   amplifier   sampling                      I1
                        resistor
                        Rsa                    1        I2
                                                        Z
                operational          Va1   Vz2    2
AD    LPF   amplifier
V1
AD                                              Vz1
V2    LPF   operational amplifier
AD    LPF

system
controller

Fig. 11

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 200610080637 B

- JP 200610058470 20060328